# EUROPEAN PATENT SPECIFICATION

(11) **EP 3 517 828 B1**
(45) Date of publication and mention of the grant of the patent: **27.04.2022**
(21) Application number: 18382049.7
(22) Date of filing: 29.01.2018
(51) Int. Cl.: F21S 41/19, H05K 3/36, F21S 41/143, F21S 45/47

(54) **AUTOMOTIVE LIGHTING MODULE AND AUTOMOTIVE LIGHTING DEVICE**
AUTOBELEUCHTUNGSMODUL UND AUTOBELEUCHTUNGSVORRICHTUNG
MODULE D'ÉCLAIRAGE AUTOMOBILE ET DISPOSITIF D'ÉCLAIRAGE AUTOMOBILE

(43) Date of publication of application: 31.07.2019
(73) Proprietor: Valeo Iluminacion, 23600 Martos (ES)
(72) Inventor: RUBIA, Juan-Antonio, 23600 MARTOS (ES); RODRIGUEZ, Lidia, 23600 MARTOS (ES); DONAIRE, Juan, 23600 MARTOS (ES); GONZALEZ, Angel, 23600 MARTOS (ES); GOMEZ, Andres, 23600 MARTOS (ES); FERNANDEZ-SENDARRUBIAS, Daniel, 23600 MARTOS (ES)
(74) Representative: Valeo Visibility

(56) References cited:
- DE-A1-102013 108 877
- DE-U1-202004 003 793
- US-A1- 2008 025 028
- US-A1- 2009 262 544
- US-A1- 2014 218 954
- US-B1- 9 328 891

## Description

### TECHNICAL FIELD

This invention is related to the field of automotive lighting devices, and more particularly, to the electric connection between the elements comprised in the lighting modules and the rest of the lighting device.

### STATE OF THE ART

Automotive lighting devices comprise an increasing number of elements and electrical connections. These elements usually require being connected to the main connector of the automotive lighting device.

However, the fact that these elements are located in different and sometimes hidden locations make that connecting them to the main connector becomes a difficult task. A multitude of wire harnesses may become trapped or entangled and, due to this fact, correct operation of the resulting lighting device is not always guaranteed.

Known lighting device is disclosed in DE 10 2013 108 877 A1 wherein the lighting device includes a main support which provides electric supply and/or signals to at least one printed circuit board

A lighting device which may overcome these problems is therefore sought.

### DESCRIPTION OF THE INVENTION

The invention provides a solution for this problem by means of a lighting device according to claim 1. Preferred embodiments of the invention are defined in dependent claims.

In an inventive aspect, the invention provides a lighting device for an automotive vehicle according to claim 1.

This main support serves as a common bus connector for the first and second printed circuit boards. When these first and second printed circuit boards contain several electronic light sources, which require control signals and electric power, the size of the harness required by every printed circuit board would make the lighting module be surrounded by harnesses, making it difficult the correct connection and operation of this lighting module inside the automotive lighting device.

Since there may be many printed circuit boards in the lighting module, and each element may have different expansion strains, it is useful that the main support, which is attached to all of them, have some grooves to absorb the different expansion strains, so that no excessive stress is generated in the main support.

This particular arrangement of the expansion grooves helps the strains to be distributed in a more symmetric way that in the case of the grooves starting in the same side of the main support.

In some particular embodiments, the main support is a printed circuit board. A standard printed circuit board is a cheap and easy embodiment of this invention, since the only requirement for the main support is that it is able to transmit the electric supply and signals from the main connector to each one of the printed circuit boards.

In some particular embodiments, the main support forms between 70 and 110 degrees with the first and second printed circuit boards.

An arrangement which is substantially perpendicular to the printed circuit boards of the lighting module is advantageous, since the main support may transversally reach all the printed circuit boards without substantially modify the design or operation of the lighting module.

In some particular embodiments, the main support comprises guide connectors to guide the fixation of the first and second printed circuit boards to the main support.

These guide connectors are intended to improve and ensure the electrical connection between each one of the printed circuit boards and the main support.

In some particular embodiments, the automotive lighting module comprises a main body, so that the first and second printed circuit boards are fixed to the main body, and the main support is fixed to the main body by means of a bolt and an oblong hole comprised in the main support.

Using an oblong hole with a bolt limits the movement of the main support in two directions, but allows the movement in one adjusting direction. Since there may be many printed circuit boards in the lighting module, and the manufacturing tolerances may not be very accurate, it is useful that the main support has a play to move for better adapting the positions of the different printed circuit boards.

In some particular embodiments, the main body comprises a reference rib and the main support comprises a reference slot suitable for receiving the reference rib. This helps better positioning of the main support with respect of the main body.

In a further inventive aspect, the invention provides an automotive lighting device comprising an automotive lighting module according to the previous inventive aspect.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows an automotive lighting module according to the invention.
Figure 2 shows a side view of the automotive lighting module of Figure 1.
Figure 3 shows a detail of the connection between elements of the automotive lighting module of Figure 1.
Figure 4 shows an automotive lighting device comprising an automotive lighting module according to the invention.

### DETAILED DESCRIPTION OF THE INVENTION

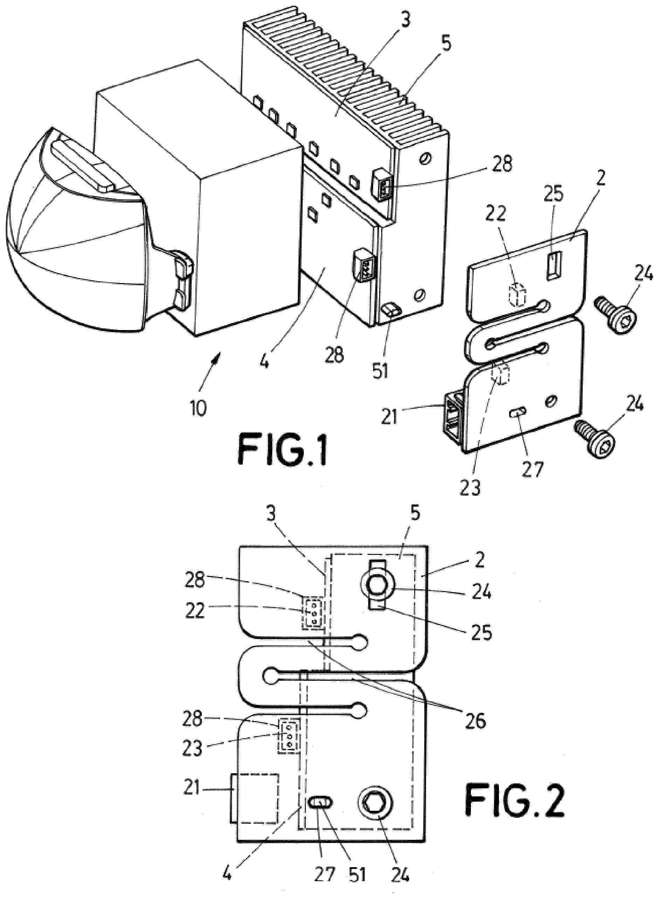

Figure 1 shows a disassembled view of an automotive lighting module 10 according to the invention.

Such a lighting module 10 comprises
a main body 5;
a main support board 2;
a first printed circuit board 3; and
a second printed circuit board 4.

In operation, the main support board 2 is fixed to the main body 5 and comprises a main connector 21 and a first 22 and second 23 auxiliary connectors. These first 22 and second 23 auxiliary connectors are in electrical connection with the main connector 21, so that any electrical supply or electric signal may be transmitted from the main connector 21 to the auxiliary connectors 22, 23.

In operation, the first printed circuit board 3 is fixed directly to the main support board 2 and is electrically connected to the first auxiliary connector 22 by means of a guide connector 28. It is therefore physically and electrically connected to the main support board 2.

In operation, the second printed circuit board 4 is fixed directly to the main support board 2 and is electrically connected to the second auxiliary connector 23 by means of a guide connector 28. It is therefore physically and electrically connected to the main support board 2.

When the main support board 2 is connected to a main supply, it is suitable for providing electric supply and signals to the first 3 and second 4 printed circuit boards.

There is no specific requirement for the main support board 2 in terms of flexibility, so a standard printed circuit board is perfectly suitable for this role.

The main support board 2 is substantially perpendicular to the first 3 and second 4 printed circuit boards. The location of this main support board 2 is therefore transversal to the position of the first 3 and second 4 printed circuit boards, thus making it easy to reach these printed circuit boards and to present the main connector 21 in location which is very accessible to the operator who connects this main connector 21 to the housing of the lighting device.

Such a lighting module 10 presents the operator only one main connector 21 to connect the lighting module 10 to the lighting device housing, regardless the number of internal printed circuit boards and their complexity.

Further, the main body 5 comprises a reference rib 51 and the main support board 2 comprises a reference slot 27 suitable for receiving the reference rib 51 for a better positioning of the main support board 2 with respect of the main body 5.

This main support board 2 is fixed to the main body 5 of the lighting module 10 by means of a bolt 24 which crosses an oblong hole 25 comprised in the main support board 2 and fixes to the main body 5. This oblong hole 25 allows the relative movement of the main support board 2 with respect to the main body 5 in a single direction. The possibility of this relative movement in one direction is important, since the adjustment between the printed circuit boards 3, 4 of the automotive lighting module 10 may require the main support board 2 to move slightly in this direction.

Figure 2 shows a side view of the lighting module 10, so that the connection between the main connector 21 and the main body 5 of the lighting module 10 is seen.

The first 3 and second 4 printed circuit boards are fixed to the main body 5, and are not visible in this figure because the main support board 2 is before them in this figure.

The main support board 2 also comprises expansion grooves 26, to absorb expansion stresses so that the distance between the first 21 and second 22 auxiliary connectors adapts to the position of the first 3 and second 4 printed circuit boards.

One of the expansion grooves 26 starts in a first side of the main support board 2 and another expansion groove 26 starts in a second side opposite to the first side. This makes that the main support board 2 has a "S" configuration, which is very useful for absorbing the different expansion strains of the elements connected to the main support board 2.

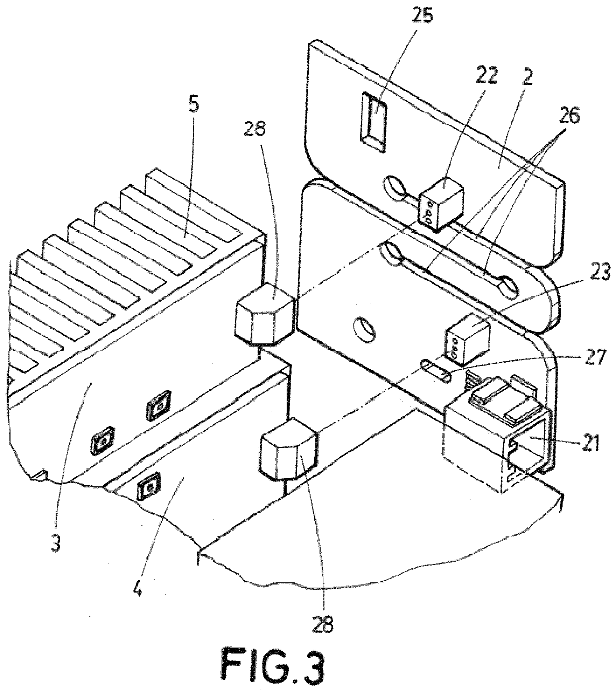

Figure 3 shows a detail of the connection between the main support board 2 and the first 3 and second 4 printed circuit boards.

As seen in this figure, each one of the first 3 and second 4 printed circuit boards comprises guide connectors 28 to guide the fixation of the first 22 and second 23 auxiliary connectors of the main support board 2.

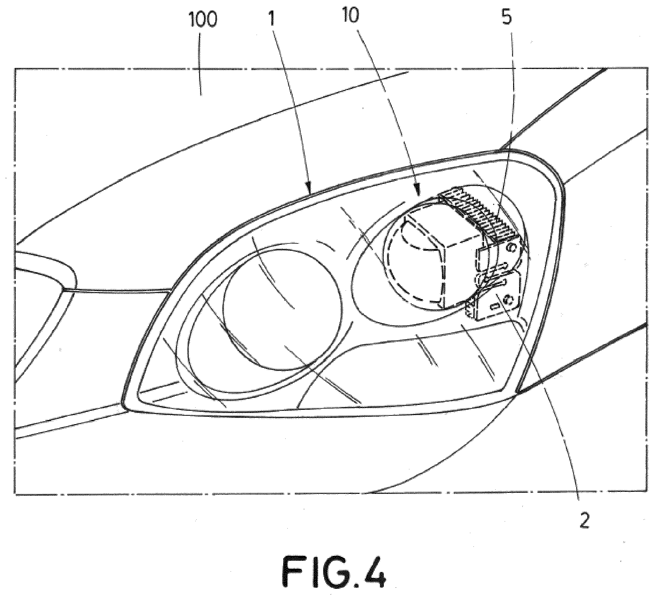

Figure 4 shows an automotive lighting device 1 comprising an automotive lighting module 10 as the one shown in the previous figures installed in an automotive vehicle 100.

## Claims

1. Automotive lighting module (10) comprising
a main support (2), comprising a main connector (21) and a first (22) and second (23) auxiliary connectors, which are in electrical connection with the main connector (21);
a first printed circuit board (3) which is fixed directly to the main support (2) and is electrically connected to the first auxiliary connector (22); and
a second printed circuit board (4) which is fixed directly to the main support (2) and is electrically connected to the second auxiliary connector (23);
wherein when the main support (2) is connected to a main supply by means of the main connector (21), the main support (2) is suitable for providing electric supply and/or signals to the first (3) and second (4) printed circuit boards
**characterized in that**
- the main support (2) comprises expansion grooves (26), to absorb expansion stresses so that the distance between the first (22) and second (23) auxiliary connectors adapts to the position of the first (3) and second (4) printed circuit boards;
- one expansion groove (26) starts in a first side of the main support (2) and another expansion groove (26) starts in a second side different from the first side; and
- the first side and the second side are opposite.

2. Automotive lighting module (10) according to claim 1, wherein the main support (2) is a printed circuit board.

3. Automotive lighting module (10) according to any of the preceding claims, wherein the main support (2) forms between 70 and 110 degrees with the first (3) and second (4) printed circuit boards.

4. Automotive lighting module (10) according to any of the preceding claims, wherein the first (3) and second (4) printed circuit boards comprise guide connectors (28) to guide the fixation of the first (22) and second (23) auxiliary connectors.

5. Automotive lighting module (10) according to any of the preceding claims, comprising a main body (5), so that the first (3) and second (4) printed circuit boards are fixed to the main body (5), and the main support (2) is fixed to the main body (5) by means of a bolt (24) and an oblong hole (25) comprised in the main support (2).

6. Automotive lighting module (10) according to any of the preceding claims, wherein the main body (5) comprises a reference rib (51) and the main support (2) comprises a reference slot (27) suitable for receiving the reference rib (51) for better positioning of the main support (2) with respect of the main body (5).

7. Automotive lighting device comprising an automotive lighting module (10) according to any of the preceding claims.

## Patentansprüche

1. Autobeleuchtungsmodul (10), umfassend:
einen Hauptträger (2), der einen Hauptverbinder (21) und einen ersten (22) und einen zweiten (23) Hilfsverbinder umfasst, die mit dem Hauptverbinder (21) in elektrischer Verbindung stehen;
eine erste Leiterplatte (3), die direkt am Hauptträger (2) befestigt und elektrisch mit dem ersten Hilfsverbinder (22) verbunden ist; und
eine zweite Leiterplatte (4), die direkt am Hauptträger (2) befestigt und elektrisch mit dem zweiten Hilfsverbinder (23) verbunden ist;
wobei, wenn der Hauptträger (2) mittels des Hauptverbinders (21) mit einer Hauptversorgung verbunden ist, der Hauptträger (2) dazu geeignet ist, die erste (3) und die zweite (4) Leiterplatte mit elektrischem Strom und/oder Signalen zu versorgen, **dadurch gekennzeichnet, dass**
- der Hauptträger (2) Dehnungsnuten (26) aufweist, um Dehnungsspannungen aufzunehmen, sodass sich der Abstand zwischen dem ersten (22) und dem zweiten (23) Hilfsverbinder an die Position der ersten (3) und der zweiten (4) Leiterplatte anpasst;
- eine Dehnungsnut (26) in einer ersten Seite des Hauptträgers (2) beginnt und eine weitere Dehnungsnut (26) in einer zweiten, von der ersten Seite verschiedenen Seite beginnt; und
- die erste Seite und die zweite Seite einander gegenüber liegen.

2. Autobeleuchtungsmodul (10) gemäß Anspruch 1, wobei der Hauptträger (2) eine Leiterplatte ist.

3. Autobeleuchtungsmodul (10) gemäß einem der vorhergehenden Ansprüche, wobei der Hauptträger (2) zwischen 70 und 110 Grad mit der ersten (3) und zweiten (4) Leiterplatte bildet.

4. Autobeleuchtungsmodul (10) gemäß einem der vorhergehenden Ansprüche, wobei die erste (3) und die zweite (4) Leiterplatte Führungsverbinder (28) aufweisen, um die Befestigung des ersten (22) und des zweiten (23) Hilfsverbinders zu führen.

5. Autobeleuchtungsmodul (10) gemäß einem der vorhergehenden Ansprüche, umfassend einen Hauptkörper (5), sodass die erste (3) und die zweite (4) Leiterplatte am Hauptkörper (5) befestigt sind, und der Hauptträger (2) am Hauptkörper (5) mittels einer Schraube (24) und eines im Hauptträger (2) enthaltenen Langlochs (25) befestigt ist.

6. Autobeleuchtungsmodul (10) gemäß einem der vorhergehenden Ansprüche, wobei der Hauptkörper (5) eine Referenzrippe (51) und der Hauptträger (2) einen zur Aufnahme der Referenzrippe (51) geeigneten Referenzschlitz (27) aufweist, um den Hauptträger (2) in Bezug auf den Hauptkörper (5) besser zu positionieren.

7. Autobeleuchtungsvorrichtung, umfassend ein Autobeleuchtungsmodul (10) gemäß einem der vorhergehenden Ansprüche.

## Revendications

1. Module lumineux d'automobile (10), comprenant
un support principal (2), comprenant un connecteur principal (21) et un premier (22) et un second (23) connecteurs auxiliaires, qui sont en connexion électrique avec le connecteur principal (21 ) ;
une première carte de circuit imprimé (3) qui est fixée directement au support principal (2) et est électriquement connectée au premier connecteur auxiliaire (22) ; et
une seconde carte de circuit imprimé (4) qui est fixée directement au support principal (2) et est électriquement connectée au second connecteur auxiliaire (23) ;
dans lequel, lorsque le support principal (2) est connecté à une alimentation réseau au moyen du connecteur principal (21), le support principal (2) est approprié pour fournir une alimentation et/ou des signaux électriques aux première (3) et seconde (4) cartes de circuit imprimé,
**caractérisé en ce que**
- le support principal (2) comprend des rainures de dilatation (26), pour absorber des contraintes de dilatation pour que la distance entre les premier (22) et second (23) connecteurs auxiliaires s'adapte à la position des première (3) et seconde (4) cartes de circuit imprimé ;
- une rainure de dilatation (26) commence dans un premier côté du support principal (2) et une autre rainure de dilatation (26) commence dans un second côté différent du premier côté ; et
- le premier côté et le second côté sont opposés.

2. Module lumineux d'automobile (10) selon la revendication 1, dans lequel le support principal (2) est une carte de circuit imprimé.

3. Module lumineux d'automobile (10) selon l'une quelconque des revendications précédentes, dans lequel le support principal (2) forme entre 70 et 110 degrés avec les première (3) et seconde (4) cartes de circuit imprimé.

4. Module lumineux d'automobile (10) selon l'une quelconque des revendications précédentes, dans lequel les première (3) et seconde (4) cartes de circuit imprimé comprennent des connecteurs de guidage (28) pour guider la fixation des premier (22) et second (23) connecteurs auxiliaires.

5. Module lumineux d'automobile (10) selon l'une quelconque des revendications précédentes, comprenant un corps principal (5), pour que les première (3) et seconde (4) cartes de circuit imprimé soient fixées au corps principal (5), et le support principal (2) soit fixé au corps principal (5) au moyen d'un boulon (24) et d'un trou oblong (25) compris dans le support principal (2).

6. Module lumineux d'automobile (10) selon l'une quelconque des revendications précédentes, dans lequel le corps principal (5) comprend une nervure de référence (51) et le support principal (2) comprend une fente de référence (27) appropriée pour recevoir la nervure de référence (51) pour un meilleur positionnement du support principal (2) par rapport au corps principal (5).

7. Dispositif lumineux d'automobile, comprenant un module lumineux d'automobile (10) selon l'une quelconque des revendications précédentes.
